# EUROPÄISCHE PATENTANMELDUNG

(11) **EP 0 786 869 A1**
(43) Veröffentlichungstag der Anmeldung: **30.07.1997**
(21) Anmeldenummer: 97400170.3
(22) Anmeldetag: 24.01.1997
(51) Int. Cl.: H03K 17/28, H03K 17/22

(54) **Schutzschaltung zum Einschalten verschieden grosser Versorgungsspannungen für eine hybride Schaltungsanordnung**

(30) Priorität: 27.01.1996 DE 19603008
(71) Anmelder: ALCATEL ALSTHOM COMPAGNIE GENERALE D'ELECTRICITE, 75008 Paris (FR)
(72) Erfinder: Hoen, Günther, 71254 Ditzingen (DE)
(74) Vertreter: Knecht, Ulrich Karl, Dipl.-Ing.

(57) **Zusammenfassung**

Im Bereich der Schaltungstechnik sind Schaltungsanordnungen mit zwei oder mehr Schaltkreisen bekannt, die unterschiedlich hohe Versorgungsspannungen benötigen und die miteinander über Signalleitungen (Datenbus) verbunden sind. Beim Einschalten der Versorgungsspannungen können auftretende Differenzspannungen Ströme hervorrufen, die über die Datenleitungen von einem Schaltkreis in den anderen fließen und dort an Signaleingängen Bauelemente zerstören. Bekannte Schutzmaßnahmen, wie etwa RC-Glieder, Schutzwiderstände oder Schutzdioden, erfordern eine aufwendige Schaltungstechnik und Eingriffe in das Layout der Schaltkreise.

Die Erfindung ist eine einfache Schutzschaltung (PCT), die Schaltmittel (S) und Verbindungsmittel (D) enthält zum Anschluß eines ersten Schaltkreises (CT1), der eine erste Versorgungsspannung (V1) benötigt, an eine geringere, zweite Versorgungsspannung (V2), die von einem zweiten Schaltkreis (CT2) benötigt wird. Mittels einer Steuerung (CTR), die mit den Schalt- und Verbindungsmitteln verbunden ist und die einen Spannungsdetektor (DET) enthält, wird beim Einschalten der beiden Versorgungsspannungen der erste Schaltkreis zunächst an die geringere, zweite Versorgungsspannung und danach an die erste Versorgungsspannung angeschlossen.

## Beschreibung

Im Bereich der Schaltungstechnik, insbesondere der digitalen Schaltungstechnik, gibt es Schaltungsanordnungen mit zwei oder mehr Schaltkreisen, die unterschiedlich hohe Versorgungsspannungen benötigen und die miteinander verbunden sind um Signale, wie etwa Datensignale, auszutauschen. Solche Schaltungsanordnungen werden auch als hybride Schaltungsanordnungen bezeichnet und enthalten etwa integrierte Schaltkreise, die Versorgungsspannungen von 5 Volt oder 3,3 Volt benötigen und die über Datenleitungen (Datenbusse) miteinander verbunden sind. Beim Einschalten der Versorgungsspannungen können auftretende Differenzspannungen Ströme hervorrufen, die von einem Schaltkreis über die Datenleitungen zu einem anderen Schaltkreis fließen und dort an Signaleingängen befindliche Bauelemente zerstören. Aufgrund der verschieden hohen Versorgungsspannungen sind vor allem die Bauelemente an den Signaleingängen der Schaltkreise, die die geringe Versorgungsspannung benötigen, gefährdet. Zum Schutz vor einer Zerstörung durch solche Ströme, deren Beträge sowohl in Spitzen als auch im Mittel hoch sein können, werden im allgemeinen die Signaleingänge mittels RC-Gliedern, Schutzwiderstände oder Schutzdioden beschaltet. Diese Maßnahmen sind jedoch aufwendig und erfordern Eingriffe in den Schaltungsentwurf (Layout) der Schaltkreise.

Aufgabe der Erfindung ist es, eine einfache Schutzschaltung zum Einschalten verschieden großer Versorgungsspannungen und eine damit ausgestattete hybride Schaltungsanordnung anzugeben.

Gelöst wird die Aufgabe durch eine Schutzschaltung nach Anspruch 1 sowie durch eine Schaltungsanordnung nach dem nebengeordneten Anspruch.

Demnach enthält die Schutzschaltung Schaltmittel und Verbindungsmittel zum Anschluß eines ersten Schaltkreises, der eine erste Versorgungsspannung benötigt, an eine geringere, zweite Versorgungsspannung, die von einem zweiten Schaltkreis benötigt wird. Weiterhin enthält die Schutzschaltung eine Steuerung, die mit den Schalt- und Verbindungsmitteln verbunden ist und die einen Spannungsdetektor sowie ein Zeitschaltglied enthält, mittels dem die Steuerung die Schaltmittel beim Einschalten der beiden Versorgungsspannungen so steuert, daß der erste Schaltkreis zunächst für eine von dem Zeitschaltglied bestimmte Zeitdauer an die geringere, zweite Versorgungsspannung und danach an die erste Versorgungsspannung angeschlossen ist.

Durch diese Maßnahmen wird beim Einschalten einer mit der Schutzschaltung ausgestatteten hybriden Schaltungsanordnung zunächst die geringere Versorgungsspannungen an alle Schaltkreise angelegt, so daß keine Differenzspannungen aufgrund unterschiedlich hoher Versorgungsspannungen auf vorhandenen Verbindungsleitungen, wie z. B. auf Datenleitungen, auftreten können. Die Schutzschaltung ist einfach aufgebaut und kann ohne Eingriff in das Layout der Schaltkreise mit diesen zu der erfindungsgemäßen Schaltungsanordnung verschaltet werden.

Vorteilhafte Ausgestaltungen der Erfindung sind den Unteransprüchen zu entnehmen.

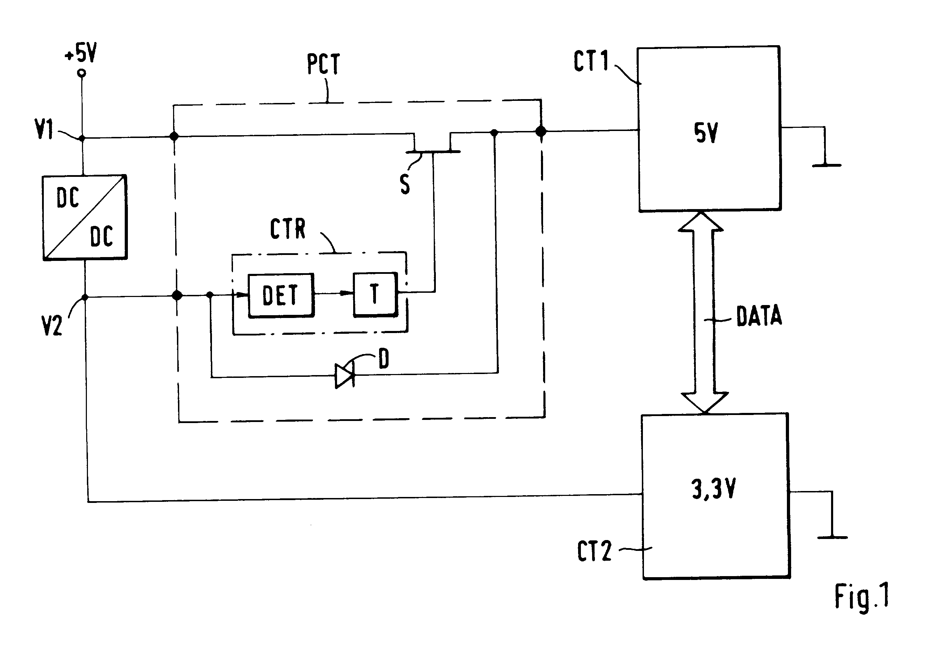

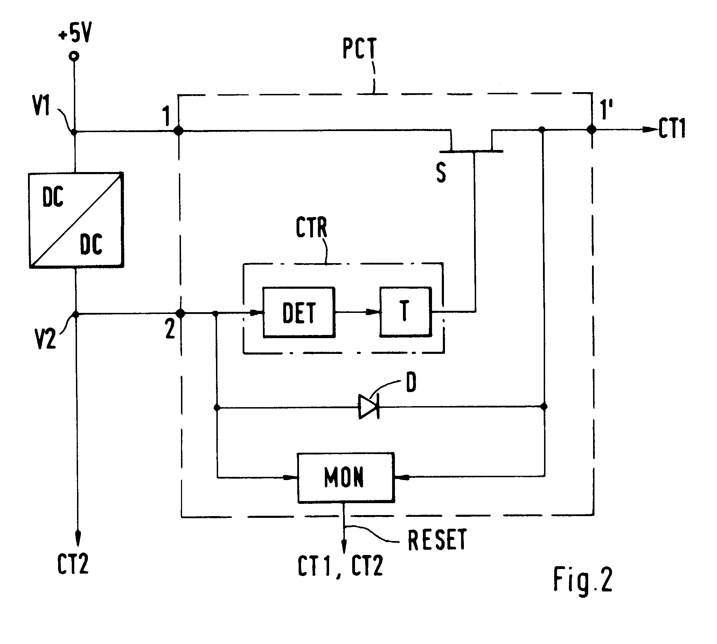

Im weiteren folgt die Beschreibung eines Ausführungsbeispiels unter Zuhilfenahme der Fig. 1 und Fig. 2, von denen:
- Fig. 1: eine Schaltungsanordnung mit zwei digitalen Schaltkreisen und mit einer Schutzschaltung zeigt, und
- Fig. 2: eine Erweiterung der Schutzschaltung nach Fig. 1 um einen Überwachungsschaltkreis zeigt.

Fig. 1 zeigt eine Schaltungsanordnung mit einem ersten Schaltkreis CT1, einem zweiten Schaltkreis CT2 und einer Schutzschaltung PCT. Die beiden Schaltkreise sind digitale Schaltkreise, wie etwa mikroprozessorgesteuerte Schaltkreise, die hier über einen Datenbus DATA miteinander verbunden sind. Die Schaltkreise CT1 und CT2 befinden sich hier beispielsweise auf zwei Leiterplatten. Der erste Schaltkreis CT1 benötigt eine erste Versorgungsspannung V1 von 5 Volt und der zweite Schaltkreis CT2 benötigt eine zweite Versorgungsspannung V2 von 3,3 Volt. Um diese beiden unterschiedlich großen Gleichspannungen bereitzustellen, enthält die Schaltungsanordnung nach Fig. 1 einen Gleichspannungswandler, der die erste Versorgungsspannung V1 = 5 Volt in die zweite, geringere Versorgungsspannung V2 = 3,3 Volt wandelt. Die Schutzschaltung PCT ist mit den beiden Schaltkreisen und dem Gleichspannungswandler folgendermaßen verschaltet:

Die Schutzschaltung PCT hat einen ersten Eingang 1, der mit dem Pluspol der ersten Versorgungsspannung V1 und somit auch mit dem Eingang des Gleichspannungswandlers verbunden ist. Demnach liegt der erste Eingang 1 der Schutzschaltung auf einem Gleichspannungspotential von plus 5 Volt. Die Schutzschaltung hat einen zweiten Eingang 2, der mit dem Ausgang des Gleichspannungswandlers und somit auch mit der zweiten Versorgungsspannung V2 verbunden ist. Demnach liegt der zweite Eingang 2 auf einem Potential von plus 3,3 Volt. Mit dem Ausgang des Gleichspannungswandlers und damit auch mit der zweiten Versorgungsspannung V2 ist auch der zweite Schaltkreis CT2 verbunden. Der erste Schaltkreis CT1 ist jedoch nicht unmittelbar mit der von ihm benötigten ersten Versorgungsspannung V1 verbunden, sondern mit einem Ausgang 1' der Schutzschaltung PCT. Die Schutzschaltung enthält nun die nachfolgend beschriebenen Bauelemente, um beim Einschalten der Versorgungsspannungen V1 und V2 den ersten Schaltkreis CT1 zunächst an die zweite Versorgungsspannung V2, das heißt an die geringere Versorgungsspannung, anzulegen:

Die Schutzschaltung PCT enthält ein zwischen dem ersten Eingang 1 und dem Ausgang 1' geschaltetes elektronisches Schaltmittel S, das hier als Feldeffekttransistor ausgeführt ist. Die Schutzschaltung enthält weiterhin eine Steuerung CTR, die zum einen mit dem Steuereingang des Feldeffekttransistors S und zum anderen mit dem zweiten Eingang 2 verbunden ist. Die Steuerung enthält einen Spannungsdetektor DET, der prüft, ob am Eingang 2 der Schutzschaltung die Versorgungsspannung V2 anliegt. Ein dem Spannungsdetektor nachgeschaltetes Zeitschaltglied T verzögert dann für eine bestimmte Zeitdauer ein Steuersignal für den Feldeffekttransistor S. Der Spannungsdetektor DET und das Zeitschaltglied T sind hier so ausgeführt, daß unmittelbar nach dem Einschalten der Versorgungsspannungen V1 und V2 der Feldeffekttransistor S nicht angesteuert wird und somit zunächst für die bestimmte Zeitdauer nicht durchschaltet. Somit wird verhindert, daß unmittelbar nach dem Einschalten der erste Schaltkreis CT1 an die erste Versorgungsspannung V1, das heißt an die höhere Versorgungsspannung, angeschlossen wird. Die Schutzschaltung PCT enthält eine als Verbindungsmittel ausgeführte Diode D, die in Durchflußrichtung eine Verbindung vom zweiten Eingang 2 zum Ausgang 1' herstellt, so daß nach dem Einschalten der Versorgungsspannung zunächst die zweite, geringere Versorgungsspannung V2 an dem ersten Schaltkreis CT1 anliegt. Die Schutzschaltung PCT bewirkt demnach, daß zunächst unmittelbar nach dem Einschalten nur die geringere Versorgungsspannung V2 an beiden Schaltkreisen CT1 und CT2 anliegt. Hierdurch wird verhindert, daß aufgrund verschiedener Versorgungsspannungen Differenzspannungen erzeugt werden, die über den Datenbus DATA zerstörend auf die Signaleingänge der Schaltkreise einwirken können.

Durch die Überwachung der geringeren Versorgungsspannung V2 am Ausgang des Gleichspannungswandlers wird bei Ausfall desselben verhindert, daß die erste Versorgungsspannung V1 zum ersten Schaltkreis CT1 durchgeschaltet wird. Dadurch sind bei Ausfall des Gleichspannungswandlers beide Schaltkreise CT1 und CT2 ohne Versorgungsspannung, wodurch das Auftreten von Differenzspannungen unterbunden ist.

Liegt nach dem Einschalten die Versorgungsspannung V2 am Spannungsdetektor DET an und ist danach die von dem Zeitschaltglied T bestimmte Zeitdauer verstrichen, so schaltet der Feldeffekttransistor S durch. Danach liegt an dem ersten Schaltkreis CT 1 die dort benötigte höhere Versorgungsspannung V1 = 5 Volt an. Die Zeitdauer wird von dem Zeitschaltglied T bestimmt und ist so groß gewählt, daß Einschwingvorgänge nach dem Einschalten abgeklungen sind, bevor am Ausgang 1' von der geringeren Versorgungsspannung V2 auf die höhere Versorgungsspannung V1 umgeschaltet wird. Das Zeitschaltglied T ist hier ein einfacher mit einem RC-Glied beschalteter Schmitt-Trigger. Die Zeitdauer ist durch Manipulation am RC-Glied einstellbar.

Die Zeitverzögerung kann auch durch eine Beschaltung des Schaltmittels S, etwa mit einem RC-Glied, erfolgen. Das von der Steuerung CTR kommende Steuersignal für den Feldeffekttransistor S ist ein logisches Steuersignal und kann auch zum Rücksetzen der Schaltkreise genutzt werden. Dazu wird das Steuersignal an die sogenannten Reset-Eingänge der beiden Schaltkreise gelegt, wo es vor und unmittelbar nach dem Einschalten in einem ersten logischen Zustand "1" verharrt. Erst wenn alle Verzögerungsspannungen nach Ablauf der Zeitdauer stabil an den Schaltkreisen anliegen, geht das Steuersignal in den anderen Zustand "0".

Die nach Fig. 1 beschriebene Schutzschaltung PCT ist sehr einfach aufgebaut, da sie im wesentlichen nur einfache Bauelemente benötigt.

In Fig. 2 ist eine besonders vorteilhafte Erweiterung der nach Fig. 1 beschriebenen Schutzschaltung PCT dargestellt. Fig. 2 zeigt den bereits beschriebenen Gleichspannungswandler sowie die damit verschalteten und bereits beschriebenen Bauelemente der Schutzschaltung PCT. Weiterhin zeigt Fig. 2 einen Überwachungsschaltkreis MON, um den die Schutzschaltung erweitert wurde. Dieser Überwachungsschaltkreis ist zum einen mit dem Eingang 2 und zum anderen mit dem Ausgang 1' verbunden, um die dort anliegenden Spannungen zu überwachen. Dazu enthält der Überwachungsschaltkreis MON nicht dargestellte Detektoren, die die Stabilität der zu überwachenden Spannungen feststellen. Der Überwachungsschaltkreis MON prüft nach dem Einschalten der Versorgungsspannungen und nach dem Verstreichen der Zeitdauer, ob die zweite Versorgungsspannung V2 stabil am zweiten Schaltkreis CT2 anliegt und ob die erste Versorgungsspannung V1 stabil am Ausgang 1', das heißt an dem ersten Schaltkreis CT1, anliegt. Sobald dies der Fall ist, setzt der Überwachungsschaltkreis MON ein Steuersignal RESET zum Rücksetzen der beiden Schaltkreise CT1 und CT2 von einem logischen Zustand "1" in den anderen logischen Zustand "0". Dadurch wird, nachdem die beiden Schaltkreise sicher eingeschaltet sind, ein Rücksetzen der in den Schaltkreisen integrierten Prozessoren bewirkt. Durch diese beschriebenen Maßnahmen ist eine sichere Inbetriebnahme der Schaltungsanordnung durch simples Einschalten der Versorgungsspannung V1 möglich. Anstelle der Verwendung des beschriebenen Gleichspannungswandlers ist auch die Verwendung zweier Gleichspannungsquellen denkbar.

Die zuvor beschriebene Schaltungsanordnung ist hier beispielsweise eine in hybrider Digitaltechnik aufgebaute Schaltungsanordnung innerhalb einer Funkfeststation für den Mobilfunk. Die beschriebene erfindungsgemäße Schaltungstechnik kann etwa für den Aufbau einer sogenannten "Frame Unit" eingesetzt werden, die bei einer TDMA-Funkübertragung die Zuweisung von Zeitschlitzen in einem TDMA-Rahmen steuert.

Das Ausführungsbeispiel soll nicht als Einschränkung der Erfindung auf digitale Gleichspannungsschaltungen verstanden werden. Vielmehr ist die Realisierung des erfindungsgemäßen Prinzips auch in zahlreichen anderen Ausführungen denkbar.

## Patentansprüche

1. Schutzschaltung (PCT) zum Einschalten von mindestens zwei miteinander verbundenen Schaltkreisen (CT1, CT2), von denen ein erster Schaltkreis (CT1) eine erste Versorgungsspannung (V1) und ein zweiter Schaltkreis (V2) eine geringere, zweite Versorgungsspannung (V2) benötigen, mit Schaltmitteln (S) und Verbindungsmitteln (D) zum Anschluß des ersten Schaltkreises (CT1) an die geringere, zweite Versorgungsspannung (V2) und mit einer Steuerung (CTR), die mit den Schalt- und Verbindungsmitteln (S, D) verbunden ist und die einen Spannungsdetektor (DET) enthält, mittels dem die Steuerung (CTR) beim Einschalten der beiden Versorgungsspannungen (V1, V2) die Schaltmittel (S) so steuert, daß der erste Schaltkreis (CT1) zunächst an die geringere zweite Versorgungsspannung (V2) und danach an die erste Versorgungsspannung (V1) angeschlossen ist.

2. Schutzschaltung (PCT)
nach Anspruch 1, bei der die Steuerung (CTR) ein mit dem Spannungsdetektor (DET) verbundenes Zeitschaltglied (T) enthält, um die Schaltmittel zeitverzögert zu steuern, und bei dem die Schaltmittel zumindest ein elektronisches Schaltelement (S) umfassen, das nach Verstreichen einer von dem Zeitschaltglied (T) bestimmten Zeitdauer den ersten Schaltkreis (CT1) von der zweiten auf die erste Versorgungsspannung (V1) aufschaltet.

3. Schutzschaltung (PCT)
nach Anspruch 2, bei der ein Überwachungsschaltkreis (MON) vorgesehen ist, der an die beiden Versorgungsspannungen (V1, V2) angeschlossen ist, um diese zu überwachen, und der ein Steuersignal (RESET) zum Rücksetzen der Schaltkreise erzeugt, sobald nach dem Aufschalten des ersten Schaltkreises (CT1) von der zweiten auf die erste Versorgungsspannung (V1) beide Versorgungsspannungen (V1, V2) stabile Amplituden haben.

4. Schutzschaltung (PCT)
nach Anspruch 1, bei der die Verbindungsmittel eine Diode (D) umfassen, die in Durchflußrichtung einen Pluspol der zweiten Versorgungsspannung (V2) mit einer positiven Spannungsklemme des ersten Schaltkreises (CT1) verbindet.

5. Schutzschaltung (PCT)
nach Anspruch 1, bei der die von dem Zeitschaltglied (T) bestimmte Zeitdauer veränderbar ist.

6. Schaltungsanordnung mit mindestens zwei miteinander verbundenen Schaltkreisen (CT1, CT2), von dem ein erster Schaltkreis (CT1) eine erste Versorgungsspannung (V1) und ein zweiter Schaltkreis (V2) eine geringere, zweite Versorgungsspannung (V2) benötigen, mit einer Schutzschaltung (PCT) zum Einschalten der Schaltkreise, die Schaltmittel (S) und Verbindungsmittel (D) enthält zum Anschluß des ersten Schaltkreises (CT1) an die geringere, zweite Versorgungsspannung (V2) und mit einer Steuerung (CTR), die mit den Schalt- und Verbindungsmitteln (S, D) verbunden ist und die einen Spannungsdetektor (DET) enthält, mittels dem die Steuerung (CTR) beim Einschalten der beiden Versorgungsspannungen (V1, V2) die Schaltmittel (S) so steuert, daß der erste Schaltkreis (CT1) zunächst an die geringere zweite Versorgungsspannung (V2) und danach an die erste Versorgungsspannung (V1) angeschlossen ist.

7. Schaltungsanordnung nach
Anspruch 6, bei der die mindestens zwei Schaltkreise digitale Schaltkreise (CT1, CT2) sind, die miteinander über Datenleitungen (DATA) verbunden sind.

8. Schaltungsanordnung nach
Anspruch 6, bei der ein Spannungswandler vorgesehen ist, der eine der beiden Versorgungsspannungen (V1) in die andere Versorgungsspannung (V2) wandelt.
